# EUROPEAN PATENT APPLICATION

(11) **EP 1 855 313 A1**
(43) Date of publication of application: **14.11.2007**
(21) Application number: 06713744.8
(22) Date of filing: 15.02.2006
(51) Int. Cl.: H01L 21/316, C01B 33/12, H01L 21/768, H01L 23/522

(54) **PROCESS FOR PRODUCING MODIFIED POROUS SILICA FILM, MODIFIED POROUS SILICA FILM OBTAINED BY THE PROCESS, AND SEMICONDUCTOR DEVICE EMPLOYING THE MODIFIED POROUS SILICA FILM**

(30) Priority: 15.02.2005 JP 2005000037
(71) Applicant: ULVAC, INC., Chigasaki-shi, Kanagawa 253-8543 (JP); TOKYO ELECTRON LIMITED, Minato-ku Tokyo 107-8481 (JP)
(72) Inventor: FUJII, Nobutoshi c/o ULVAC, Inc., Tsukuba Institute for Su. Mat., Ibarak 3002635 (JP); KOHMURA, Kazuo c/o Mitsui Chemicals, Inc.,, Chiba, 2990265 (JP); MIYOSHI, Hidenori c/o Tokyo Electron Limited,, Tokyo, 1078481 (JP); TANAKA, Hirofumi c/o Mitsui Chemicals, Inc.,, Chiba, 2990265 (JP); OIKE, Shunsuke c/o Mitsui Chemicals, Inc.,, Chiba, 2990265 (JP); MURAKAMI, Masami c/o Mitsui Chemicals, Inc.,, Chiba, 2990265 (JP); KUBOTA, Takeshi c/o Mitsui Chemicals, Inc.,, Chiba, 2990265 (JP); KURANO, Yoshito c/o Mitsui Chemicals, Inc.,, Chiba, 2990265 (JP)
(74) Representative: AMMANN PATENTANWÄLTE AG BERN
(86) International application number: PCT/JP2006/302603
(87) International publication number: WO 2006/088036

(57) **Abstract**

A hydrophobic compound having at least one each of hydrophobic group (an alkyl group having 1 to 6 carbon atoms or a -C₆H₅ group) and polymerizable group (a hydrogen atom, a hydroxyl group or a halogen atom) is allowed to undergo a gas-phase polymerization reaction, under reduced pressure (of not more than 30 kPa), in the presence of a raw porous silica film and to thus form a modified porous silica film wherein a hydrophobic polymer thin film is formed on the inner walls of holes present in the raw porous silica film. The resulting porous silica film has a low relative dielectric constant and a low refractive index and the silica film is likewise improved in the mechanical strength and hydrophobicity. A semiconductor device is produced using the porous silica film.

## Description

### Technical Field

The present invention relates to a method for the preparation of a modified porous silica film, a modified porous silica film prepared according to this method and a semiconductor device fabricated using this modified porous silica film and the present invention, more particularly, pertains to a method for the preparation of a modified porous silica film, which has a low relative dielectric constant and a low refractive index and which is excellent in the mechanical strength and hydrophobicity, and a modified porous silica film prepared according to the method as well as a semiconductor device fabricated using this modified porous silica film.

### Background Art

In the field of LSI, techniques have recently been investigated and developed widely and actively, which make use of interlayer electrical insulating films characterized in that they have a low dielectric constant (k) on the order of not more than 2.5 in addition to the use of copper-electrical connections or Cu-distributing wires. There has been proposed the use, as such an interlayer electrical insulating film, of an oxide film which has a low dielectric constant and which has been made porous. However, the use of such a porous oxide film in turn becomes a cause of, for instance, the following variety of problems: (1) the considerable and abrupt reduction of the mechanical strength of the interlayer electrical insulating film; (2) the adsorption of moisture present in the air on the walls of pores; and (3) any reduction of the adhesion between the porous film and a film adjacent to the same due to the presence of, for instance, CH₃ groups introduced into the porous film for the solution of the foregoing problem concerning the moisture adsorption. For this reason, in the process for practically applying the porous film to semiconductor devices and, in particular, in CMP (Chemical Mechanical Polishing) step in the copper dual damascene process for forming an electrical connection structure, in the wire-bonding process and the like, the foregoing techniques suffer from a variety of problems, for instance, the breakage of the porous film due to the lowering of its mechanical strength, an increase in the dielectric constant due to the moisture absorption, and the occurrence of any separation of a laminated film from the porous electrical insulating film due to the reduction of the adhesion between them and this accordingly becomes a serious obstacle in putting the porous film into practical use.

Moreover, it has been confirmed that light rays of high brightness can be extracted by applying a silica aerosol thin film onto such a porous film as a layer having a low refractive index and the subsequent application of a transparent electroconductive film thereon, for the purpose of highly efficiently extracting light rays from the light emitting portions in, for instance, a display device, for the prevention of any reflection of external light rays, or for the purpose of making external light rays incident upon, for instance, a solar cell at a high efficiency. However, even the silica aerosol thin films, which have been proposed before now, do not permit any solution of problems like those specified above such as the reduction of the mechanical strength, the adsorption of moisture on the walls of pores, and any reduction of the adhesion between the porous film and a film adjacent thereto.

To solve the foregoing problems associated with the conventional techniques, it has been known that alkoxy-silanes are hydrolyzed and condensed in the presence of a surfactant and a cyclic siloxane (such as tetramethyl cyclotetrasiloxane) to prepare a coating solution, followed by applying the resulting coating solution onto the surface of a substrate and then heating the coated film formed on the substrate surface to thus form a porous silica film (see, for instance, Japanese Un-Examined Patent Publication 2004-210579 (Claims)). In this case, however, such a heat-treatment under the ordinary pressure would, for instance, suffer from the following additional problems: (4) particles consisting of the poly(methyl siloxane) formed through the polymerization reaction of tetramethyl cyclotetrasiloxane are adhered to the surface of the foregoing porous silica film and the interior of the processing chamber to thus contaminate the porous silica film and (5) it would be quite difficult to obtain the intended uniform effects when preparing a porous silica film which has a substantially large area.

### Disclosure of the Invention

### Problems That the Invention is to Solve

It is in general an object of the present invention to solve the foregoing problems associated with the conventional techniques and more particularly to provide a method for the preparation of a modified porous silica film, which has a low relative dielectric constant and a low refractive index and which is improved in the mechanical strength and hydrophobicity, and a modified porous silica film prepared according to this method as well as a semiconductor device fabricated using this modified porous silica film.

### Means for Solving the Problems

The inventors of this invention have variously investigated to prepare a modified porous silica film, which has a low relative dielectric constant and a low refractive index and which is improved in the mechanical strength and hydrophobicity, have found that the foregoing problems (1) to (5) associated with the conventional techniques can be solved by subjecting a raw porous silica film to a gas-phase polymerization reaction with a hydrophobic compound such as a specific siloxane under desired reduced pressure conditions and have thus completed the present invention on the basis of this finding.

The method for the preparation of a modified porous silica film according to the present invention comprises the step of forming a polymer thin film on the inner walls of holes present in a raw porous silica film through a gas-phase polymerization reaction of a hydrophobic compound having at least one each of hydrophobic group and polymerizable group, carried out under reduced pressure in the presence of the raw porous silica film. Such a hydrophobic compound, which is in a gaseous state, can be introduced into holes present in the raw porous silica film and can be polymerized through the gas-phase polymerization reaction therein to form a hydrophobic polymer thin film on the inner walls of the holes and to thus ensure the bond between the thin film and the inner walls of the holes. Thus, excellent hydrophobicity can be imparted to the modified porous silica film per se and the hole-structure of the porous film can simultaneously be reinforced or strengthened by the action of the polymer thin film attached to the inner walls of the holes. This in turn leads to the improvement of the mechanical strength (such as the elastic modulus and hardness) of the porous silica film.

The foregoing hydrophobic group is an alkyl group having 1 to 6 carbon atoms or a group: -C₆H₅, while the foregoing polymerizable group is preferably a hydrogen atom, a hydroxyl group or a halogen atom. When using an alkyl group having more than 6 carbon atoms as the hydrophobic group, the molecular size of the hydrophobic compound is extremely large and this accordingly adversely affects the degree of the dispersion thereof in the holes of the porous silica film.

The foregoing hydrophobic compound is preferably an organic silicon atom-containing compound having at least one bond represented by the formula: Si-X-Si (in the formula, X represents an oxygen atom, an NR group, a -CₙH₂ₙ group, or a -C₆H₄ group, R represents -CₘH₂ₘ₊₁ group or a -C₆H₅ group, n is an integer of 1 or 2, m is an integer ranging from 1 to 6) and at least two bonds represented by the formula: Si-A (in the formula, A represents a hydrogen atom, a hydroxyl group, a -OCₑH₂ₑ₊₁ group or a halogen atom, a plurality of groups A present in the same molecule may be the same or different, and e is an integer ranging from 1 to 6).

The foregoing hydrophobic compound is preferably a cyclic siloxane compound.

The foregoing reduced pressure used in the gas-phase polymerization reaction preferably falls within the range of from 1 × 10⁻⁵Pa to 30kPa. The use of an inner pressure of the chamber of not more than 30kPa would permit the improvement of the dispersibility of the hydrophobic compound within the chamber, the establishment of a uniform concentration of the compound in the holes, and the efficient production of a desired polymer thin film. If the reduced pressure used exceeds 30kPa, a problem arises such that particles consisting of, for instance, the polymer (such as polymethyl-siloxane) formed through the polymerization reaction are adhered to the surface of the porous silica film and the interior of the processing chamber to thus contaminate the desired porous silica film.

In addition, the modified porous silica film of the present invention is characterized in that it is prepared according to the method specified above.

Furthermore, the semiconductor material according to the present invention is characterized in that it comprises the modified porous silica film described above.

Moreover, the semiconductor device according to the present invention is characterized in that it is prepared using the semiconductor material specified above.

### Effects of the Invention

The preparation method according to the present invention would permit the formation of a modified porous silica film, which has a low relative dielectric constant and a low refractive index and which is improved in the mechanical strength and hydrophobicity and the method can provide a modified porous silica film having such characteristic properties. Accordingly, the present invention can likewise provide a useful semiconductor material obtained using this modified porous silica film as well as a useful semiconductor device prepared using the semiconductor material specified above.

### Best Mode for Carrying Out the Invention

The porous silica film used as a raw material for preparing the modified porous silica film according to the present invention is not restricted to any particular one insofar as it has pores having a desired pore size. For instance, the porous silica film may be one obtained by preparing a solution of a silicon alkoxide which is an organic silane as a precursor of such a porous silica material, then subjecting the resulting solution to an acid hydrolysis or an alkali hydrolysis and finally heat-treating the hydrolyzed solution to thus remove, through evaporation, the water, acid or alkaline catalysts, surfactant, optionally added solvents such as alcohols or the like present in the precursor solution and simultaneously eliminating other organic substances possibly present in the reaction system, or one obtained by adding a silicon atom-containing organic compound carrying a hydrophobic group such as an alkyl group to the foregoing silicon alkoxide solution, subjecting the resulting solution to an acid hydrolysis or an alkali hydrolysis and finally heat-treating the hydrolyzed solution to thus remove, through evaporation, the water, acid or alkaline catalysts, surfactant, optionally added solvents such as alcohols or the like present in the precursor solution and simultaneously eliminating other organic substances possibly present in the reaction system.

The foregoing organic silanes usable herein may be, for instance, silicon alkoxides capable of being hydrolyzed such as tetraethoxy-silane (TEOS) and tetramethoxy-silane (TMOS). Specific examples of organic silanes usable herein also include quaternary alkoxy silanes such as tetraisopropoxy silane and tetrabutyl silane; tertiary alkoxy fluorosilanes such as trimethoxy fluorosilane, triethoxy fluorosilane, tri-isopropoxy fluorosilane and tri-butoxy fluorosilane; tertiary alkoxyalkyl silane such as trimethoxy-methyl silane, triethoxy-methyl silane, trimethoxy-ethyl silane, triethoxy-ethyl silane, trimethoxy-propyl silane and triethoxy-propyl silane; tertiary alkoxy-aryl silanes such as trimethoxy-phenyl silane, triethoxy-phenyl silane, trimethoxy chlorophenyl silane and triethoxy chlorophenyl silane; tertiary alkoxy-phenethyl silanes such as trimethoxy-phenethyl silane and triethoxy-phenethyl silane; and secondary alkoxyalkyl silanes such as dimethoxy-dimethyl silane and diethoxy-dimethyl silane. Among them, preferably used herein is tetraethoxy silane since the use of this silane would make, quite easy, the control of the hydrolysis reaction thereof carried out at room temperature. The silicon alkoxides listed above may be used alone or in any combination of at least two of them.

The hydrolysis used herein may be an acid or alkaline hydrolysis and it would be possible to use, in the hydrolysis, an inorganic acid such as hydrochloric acid, hydrobromic acid, nitric acid or sulfuric acid; an organic acid such as formic acid; or an alkali such as ammonia.

The foregoing solvents may be, for instance, primary alcohols such as methanol, ethanol and 1-propanol; secondary alcohols such as 2-propanol and 2-butanol; tertiary alcohols such as tertiary butyl alcohol; acetone; and acetonitrile. They may be used alone or in any combination of at least two of them as such a solvent.

The surfactants, which may be used in the preparation of a coating solution for forming,a raw porous silica film according to the present invention may preferably be, for instance, a compound having a polyalkylene oxide structure. Specific examples of such polyalkylene oxide structures include polyethylene oxide structure, polypropylene oxide structure, polytetra-methylene oxide structure and polybutylene oxide structure.

The compounds each having a polyalkylene oxide structure may be, for instance, ether type ones such as polyoxyethylene polyoxypropylene block copolymers, polyoxyethylene polyoxypropylene alkyl ethers, polyethylene alkyl ethers and polyoxyethylene alkylphenyl ethers; and ether ester type ones such as polyoxyethylene glycerin fatty acid esters, polyoxyethylene sorbitan fatty acid esters, polyethylene sorbitol fatty acid esters, sorbitan fatty acid esters, propylene glycol fatty acid esters and sucrose fatty acid esters.

The surfactants listed above can be used herein alone or in any combination of at least two of them. The surfactant used herein may be in any form such as a solid state or a solution obtained by the dissolution thereof in the solvent insomuch as it is added to the foregoing precursor solution in an amount specified above.

The foregoing surfactant forms micelles in water, in which the molecules thereof are regularly arranged. The surfactant molecules form a complex with silica while making use of such a micelle as a template and then the template can be removed to thus give a porous silica film having fine pores uniformly and regularly arranged therein.

The foregoing silicon atom-containing organic compounds each carrying a hydrophobic group such as an alkyl group may be, for instance, silane compounds each carrying methyl group(s) such as hexa-methyl disilane, dimethyl diethoxy silane, methyl trimethoxy silane, methyl triethoxy silane, triethoxy silane and dimethyl dimethoxy silane; disilazane compounds each carrying methyl group(s) such as hexa-methyl disilazanes; or siloxane compounds each carrying methyl group(s) such as hexa-methyl disiloxanes.

The raw porous silica film can, for instance, be obtained by applying the foregoing precursor solution containing a porous silica material onto the surface of a substrate using the usual coating method, then subjecting the coated layer to a heat-treatment using any known means such as infrared heating oven to thus eliminate or remove the water-alcohol solvent, the acid or alkali catalyst, the surfactant, other substances or the like through evaporation and to thus form a porous silica film on the substrate. In this case, the conditions for the heat-treatment are not restricted to specific ones insofar as they permit the evaporation of the solvents, the acid or alkali catalysts, the surfactants or the like to thus form a desired porous silica film on the substrate. To form a porous silica film having a low relative dielectric constant, it is preferred that the coated layer is first treated in the air at a temperature ranging from about 50 to 350°C to thus mainly evaporate or remove the solvents or the like and the coated layer is then heat-treated in a vacuum or a pressure ranging, for instance, from about 100 to 10⁻⁵ Pa, at a temperature (for instance, ranging from 250 to 500°C), which is sufficient for the evaporation of, for instance, the surfactants and other organic substances for a time period which never causes any breakage of the pore structures of the resulting porous silica film. It is a matter of course that these heat-treatments should be carried out in an inert gas atmosphere or in a vacuum if the treatment may adversely be affected by, for instance, oxidation.

Alternatively, the raw porous silica film can be formed by the use of the following coating solution. Such a coating solution may be prepared by, for instance, blending the foregoing alkoxy silanes, surfactants, catalysts and water, incorporating, if necessary, a solvent into the resulting mixture and then stirring the mixture over a predetermined time period; or it is also possible to prepare such a coating solution by blending the foregoing alkoxy silanes, catalysts and water, incorporating, if necessary, a solvent into the resulting mixture, followed by stirring the resulting mixture over a predetermined time to thus partially hydrolyze and/or condense, through dehydration, the alkoxy silanes, and further adding, if necessary, surfactants dissolved in a solvent to the mixture and then stirring the mixture over a predetermined time period. It would be recognized that the hydrophobic groups of the surfactants are regularly arranged to form micelles in the coating solution thus prepared and therefore, the diameter of the resulting micelles increases. For this reason, the porous silica film prepared using the coating solution containing such micelles may have an increased pore size, this results in an increase in the porosity thereof and this in turn leads to the formation of a porous silica film having a low dielectric constant. The coating solution prepared according to the foregoing procedures can be applied onto the surface of a substrate, the coated layer formed on the surface thereof can then be subjected to drying and the surfactants or the like can be removed through, for instance, firing to thus give a desired raw porous silica film.

The foregoing substrate usable herein may be any one insofar as it may currently be used in this field. Specific examples thereof are glass materials, quartz materials, silicon wafers and stainless steel materials. These substrates may have any shape such as plate-like and dish-like ones.

In the foregoing description, methods for the application of the coating solution onto the surface of the substrate may be, for instance, those commonly used in this field such as spin-coating techniques, cast-coating techniques, and dip-coating techniques. In the case of the spin-coating technique, a substrate is placed on a spinner and a sample solution is dropwise added to the substrate while rotating the substrate at a rate ranging from 500 to 10,000 rpm.

According to the present invention, a hydrophobic compound is then allowed to react according to a gas-phase polymerization reaction in the presence of the raw porous silica film prepared by the foregoing procedures to thus form a polymer thin film adhered to the inner walls of pores present in the raw porous silica film. In this respect, the hydrophobic compound is one having at least one hydrophobic group selected from the group consisting of alkyl groups each having 1 to 6 carbon atoms and -C₆H₅ group; and at least one polymerizable group selected from the group consisting of hydrogen atom, hydroxyl group and halogen atoms. Specific examples of such compounds are 1,2-bis(tetramethyl-disiloxanyl)-ethane, 1,3-bis(trimethyl-siloxy)-1,3-dimethyldisiloxane, 1,1,3,3-tetra-iso-propyl-disiloxane, 1,1,3,3-tetraphenyl-disiloxane, 1,1,3,3-tetraethyl-disiloxane, 1,1,4,4-tetramethyl-disiloxane, 1,1,3,3,5,5-hexamethyl-trisiloxane, 1,1,3,3,5,5-hexa-isopropyl-trisiloxane, 1,1,3,3,5,5,7,7-octamethyl-tetrasiloxane, 1,1,1,3, 5,5-hexamethyl-trisiloxane, 1,1,1,3,3,5,7,7-octamethyl-tetrasiloxane, 1,3-dimethyl-tetramethoxy-disiloxane, 1,1,3,3-tetramethyl-1,3-diethoxy-disiloxane, 1,1,3,3,5,5-hexamethyl-diethoxy-trisiloxane and tetramethyl-1,3-dimethoxy-disiloxane.

The hydrophobic compound which can be used in the present invention is an organic silicon atom-containing compound having at least one bond represented by the formula: Si-X-Si (in the formula, X represents an oxygen atom, an NR group, a -CₙH₂ₙ group, or a -C₆H₄ group, R represents -CₘH₂ₘ₊₁ group or a -C₆H₅ group, n is an integer of 1 or 2, m is an integer ranging from 1 to 6) and at least two bonds represented by the formula: Si-A (in the formula, A represents a hydrogen atom, a hydroxyl group, a -OCₑH₂ₑ₊₁ group or a halogen atom, a plurality of groups A present in the same molecule may be the same or different, and e is an integer ranging from 1 to 6). Specific examples of the organic silicon atom-containing compound are 1,2,3,4,5,6-hexamethyl-cyclotrisilazane, 1,3,5,7-tetraethyl-2,4,6,8-tetramethyl-cyclotetrasilazane, 1,2,3-triethyl-2,4,6-triethyl-cyclotrisilazane.

The foregoing hydrophobic compound may be used in an amount sufficient for forming a polymer thin film on the inner walls of pores on the basis of the raw porous silica film and the concentration thereof in the gas is preferably on the order of not less than 0.1% by volume.

According to the present invention, it is also possible to use a cyclic siloxane as such a hydrophobic compound and, in this case, a polymer of such a cyclic siloxane is formed on the inner walls of pores present in the raw porous silica film.

The cyclic siloxanes usable herein may preferably be at least one member selected from the group consisting of those represented by the following general formula: 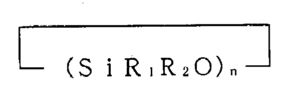 (In the general formula, R₁ and R₂ may be the same or different and each represents H, a -C₆H₅ group, a -CₐH₂ₐ₊₁ group, a CF₃(CF₂)_{b}(CH₂)_{c} group, or a halogen atom, a is an integer ranging from 1 to 3, b is an integer ranging from 0 to 10, c is an integer ranging from 0 to 4, and n is an integer ranging from 3 to 8).

The cyclic siloxane represented by the foregoing general formula is preferably one having two or more Si-H bonds in the molecule, and it is also preferred that either one of or the both of the substituents R₁ and R₂ are H atoms.

The use of such a cyclic siloxane would permit the formation of a porous silica film having a large pore size and likewise permit the increase of the porosity thereof and therefore, the resulting porous silica film accordingly has a reduced dielectric constant.

Specific examples of such cyclic siloxanes are tri(3,3,3-trifluoro-propyl)-trimethyl cyclotrisiloxane, triphenyl-trimethyl cyclotrisiloxane, 1,3,5,7-tetra-methyl cyclotetrasiloxane, octa-methyl cyclotetrasiloxane, 1,3,5,7-tetra-methyl-1,3,5,7-tetraphenyl cyclotetrasiloxane, tetraethyl cyclotetrasiloxane and penta-methyl cyclopentasiloxane. The cyclic siloxanes usable in the present invention may be at least one member selected from the group consisting of those listed above. Among the foregoing cyclic siloxanes, preferably used in the present invention is 1,3,5,7-tetramethyl cyclotetra-siloxane.

In addition, the cyclic siloxanes usable herein may likewise be at least one member selected from the group consisting of those represented by the following general formula: 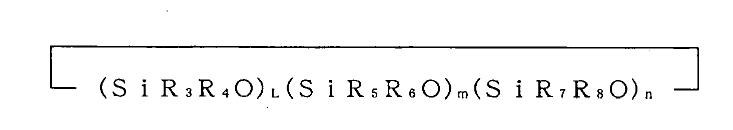 (In the general formula, R₃, R₄, R₅, R₆, R₇ and R₈ may be the same or different and each represents H, a -C₆H₅ group, a -CₐH₂ₐ₊₁ group, a CF₃(CF₂)_{b}(CH₂)_{c} group, or a halogen atom, a is an integer ranging from 1 to 3, b is an integer ranging from 0 to 10, c is an integer ranging from 0 to 4, L is an integer ranging from 0 to 8, m is an integer ranging from 0 to 8 and n is an integer ranging from 0 to 8, provided that these L, m and n satisfy the following relation: 3≦L+m+n≦8, and that the compound comprises at least two Si-H bonds).

Furthermore, the cyclic siloxanes usable herein may likewise be at least one member selected from the group consisting of those represented by the following general formula: 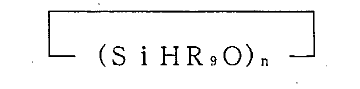 (In the general formula, R₉ represents H, a -C₆H₅ group, a -CₐH₂ₐ₊₁ group, a CF₃(CF₂)_{b}(CH₂)_{c} group, or a halogen atom, a is an integer ranging from 1 to 3, b is an integer ranging from 0 to 10, c is an integer ranging from 0 to 4 and n is an integer ranging from 3 to 8).

According to the modified porous silica film-preparation method of the present invention, the use of an organic silicon atom-containing compound such as a cyclic siloxane under reduced pressure permits the formation of a hydrophobic modified porous silica film having a dielectric constant lower than that observed for the porous silica film prepared without using any cyclic siloxanes. In addition, when carrying out the treatment under desired reduced pressure conditions, the cyclic siloxane undergoes polymerization on the inner walls of the pores present in the porous silica film to cover the inner walls thereof with a thin film of a polymer carrying hydrophobic functional groups and to thus form a porous silica film excellent in the hydrophobicity. Accordingly, the present invention permits the production of a porous silica film excellent in, for instance, its dielectric constant and hydrophobicity without additionally subjecting the modified porous silica film to any treatment for making the film hydrophobic after the preparation of the modified porous silica film.

As has been described above, the modified porous silica film-preparation method of the present invention permits the formation of a hydrophobic polymer thin film of, for instance, a polysiloxane on the inner walls of pores by allowing a hydrophobic compound to undergo a polymerization reaction within the pores present in a porous silica film under reduced pressure and making the resulting thin film bonding to the inner walls of the pores to thus impart excellent hydrophobicity to the modified porous silica film per se. At the same time, the pore structure of the porous film is reinforced due to the action of the polymer thin film and as a result, the mechanical strength of the porous silica film can be improved.

In this connection, there still remain un-polymerized residues of the hydrophobic compound in and/or on the porous silica film even after the foregoing treatment and therefore, when other metal thin films and/or an electrical insulating film are formed, in layers, on the modified porous silica film, the presence of these un-polymerized residues would permit the considerable improvement of the adhesion between these laminated layers.

Moreover, according to the modified porous silica film-preparation method of the present invention, the internal pressure of the processing chamber can once be reduced to a desired level (for instance, a reduced pressure on the order of not higher than 30 kPa), a vaporized hydrophobic compound can then be introduced into the processing chamber and they can thereafter be polymerized while maintaining the reduced pressure. Therefore, the dispersibility of the hydrophobic compound within the processing chamber is considerably improved and this would ensure the establishment of a uniform concentration of the compound in the pores.

Furthermore, it is also possible to remove, in advance, gas molecules and/or water molecules present in the pores of the porous silica film before the introduction of the gaseous molecules of the hydrophobic compound and therefore, the compound has a substantially improved diffusibility within the pores. As a result, the hydrophobic compound can uniformly be dispersed even in the pores within a short period of time and can undergo a polymerization reaction within the pores. Accordingly, the present invention permits the solution of the problem concerning the uniformity of the processing effect, which is encountered when handling a porous silica film having a large area.

In addition, the vapor concentration of the hydrophobic compound introduced into the chamber is sufficiently low at a reduced pressure on the order of not higher than 30 kPa and any excess polymerization reaction never takes place. For this reason, the film surface and/or the inner wall of the processing chamber would never be contaminated with the polymerization reaction products.

As has been discussed above, the modified porous silica film of the present invention is excellent in the both dielectric constant and hydrophobicity and therefore, the porous silica film can be used as a semiconductor material for forming an interlayer electrical insulating film and an electrical insulating film arranged between electrical connections; an optical functional material such as a molecular recording medium, a transparent conductive film, a solid electrolyte, an optical waveguide and a color part for LCD; and an electronic functional material. In particular, it has been required for the interlayer electrical insulating films or the electrical insulating films arranged between electrical connections as the semiconductor materials that they should have a low dielectric constant and should be hydrophobic in nature and accordingly, it is preferred to use the modified porous silica film according to the present invention having a low dielectric constant and excellent in the hydrophobicity as the semiconductor material.

A semiconductor device will now be described in more specifically, which makes use of the modified porous silica film of the present invention as the electrical insulating film arranged between electrical connections.

First of all, a modified porous silica film is formed on the surface of a substrate according to the procedures described above. The modified porous silica film-forming method of the present invention permits the formation of an electrical insulating films between electrical connections, which has a low dielectric constant and is excellent in the hydrophobicity. Then a hard mask and a photoresist layer are formed on the modified porous silica film to thus etch the silica film in the pattern corresponding to that formed on the photoresist layer. After the completion of the etching, a barrier layer consisting of, for instance, titanium nitride (TiN) or tantalum nitride (TaN) is formed on the surface of the porous silica film according to the chemical vapor deposition (CVD) technique or the vapor phase growth technique.

After the formation of the barrier film on the surface of the porous silica film according to the present invention, a copper electrical connection layer is formed according to the metal CVD technique, the sputtering technique or the electrolytic plating technique and then the resulting film is made smooth by the CMP technique. Then a capping film is formed on the film surface. Moreover, a hard mask is, if necessary, formed and the foregoing steps may be repeated to give a multi-layered structure and to thus fabricate a semiconductor device of the present invention.

In this description of the mode for carrying out the present invention, an electrical insulating film material for a semiconductor circuit element is taken by way of a preferred example, but the present invention is not restricted to such a specific example at all and accordingly, the present invention can likewise be applied to, for instance, waterproofing films as electric materials which require a surface treatment carried out in an aqueous solution, catalytic materials and filter materials.

Preparation examples in which raw porous silica films are prepared using organic silicon atom-containing compounds will be described in more detail below.

### (Preparation Example 1)

A coating solution used for forming a porous silica film was prepared using, as ingredients for the preparation of such a reaction solution, 0.7 mole of nitric acid, 12 moles of H₂O, 15 moles of ethanol and a predetermined amount (0.2 mole) of a surfactant with respect to one mole of TEOS. The resulting coating solution was applied onto the surface of a substrate according to the spin-coating technique, which was carried out at a rotational speed of 3,000 rpm. The substrate provided thereon with a coated layer was treated in the air at a temperature ranging from 200 to 400°C in the initial stage using an infrared heating oven and then it was further fired at 400°C in an atmosphere maintained at a pressure ranging from 100 to 10⁻⁵ Pa to thus form a raw porous silica film. At this stage, the time required for raising the temperature from 200°C (the temperature used for the initial heat-treatment) to 400°C (the temperature used for the subsequent firing step) was set at a level of 60 minutes. In this connection, the rate of raising the temperature is not restricted to any specific level, but it should be set at a level such that the resulting film is free of any roughened surface and the leak current is likewise small. The time required for the vacuum firing operation is not restricted to specific one insofar as it never causes any breakage of the film structure and accordingly, the firing operation was carried out for 30 minutes. The porous silica film thus prepared was observed by a scanning electron microscope (SEM) to obtain a micrograph of the cross-section thereof and to thus examine the quality and conditions of the porous film. As a result, the SEM image clearly indicates that a large number of pores are present in the porous silica film thus prepared.

A modified porous silica film, which has a low relative dielectric constant and a low refractive index and which is improved in the mechanical strength and hydrophobicity can thus be prepared when practicing the modified hydrophobic porous silica film-production method according to the present invention while making use of the porous silica film thus formed.

### Example 1

An Si substrate was introduced into a known vertical type firing oven whose pressure during firing within its processing chamber was variable and then heated to a temperature of 400°C. Thereafter there was introduced, into the firing oven, a mixed gas comprising 1,3,5,7-tetramethyl-cyclotetrasiloxane (TMCTS) gas in a flow rate of 0.7 g/min and N₂ gas as a carrier gas, while setting the pressure in the firing oven at a level of 500 Pa or the atmospheric pressure and then the firing operation was continued for 60 minutes while maintaining the pressure in the oven at that level. At this stage, the mixed gas comprising TMCTS gas + N₂ gas was always passed through the oven during the firing operation so that these gases did not remain in the oven at all. The oven was evacuated to a vacuum immediately after the completion of the firing and then the temperature thereof was reduced to thus remove the substrate from the oven.

Then Si substrate thus withdrawn from the oven was investigated to determine the number of particles present on the substrate, whose particle size was not less than 0.2 µm and as a result, it was confirmed, from the data listed in the following Table 1, that the number of such particles observed for the treatment carried out under reduced pressure was extremely lower than that observed for the treatment carried out at the atmospheric pressure.

**Table 1:**

| | | |
|---|---|---|
| Pressure | Atmospheric Pressure | 500 Pa |
| Number of Particles | Not less than 10,000 | 15 |

### Example 2

A transparent uniform coating solution was prepared by stirring, in ethanol solvent, 0.85 mole of tetraethoxy-silane (TEOS), 11 moles of water, 0.15 mole of dimethyl diethoxy silane (DMDEOS) and 0.017 mole of a nonionic surfactant (P103 available from Asahi Denka Kogyo K.K.; average molecular weight: 4600; OH(CH₂CH₂O)₁₇(CH(CH₃)CH₂O)₅₅(CH₂CH₂O)₁₇H) under a strongly acidic environment at room temperature.

In this regard, the amount of the DMDEOS is not restricted to any specific one, but if this substance is not used, the porous silica film obtained after the firing operation shows X-ray diffraction peaks which are attributable to the presence of the two-dimensional hexagonal pore-arrangement. In other words, the resulting porous silica film is completely free of any moth eaten pattern-like pore structure or the so-called Worm Hole-like pore structure and the resulting film in turn has a high relative dielectric constant.

The coating solution thus obtained was applied onto the surface of a semiconductor Si substrate according to the spin-coating technique, which was carried out at a rotational speed of 1,200 rpm. Thereafter, the substrate thus treated was introduced into a known vertical type firing oven in which the thermal vapor-phase growth technique could be performed according to the batch-wise manner and then the substrate was subjected to a firing treatment at 400°C for one hour in an atmosphere of dried pure air to thus obtain a raw porous silica film. The time required for raising the temperature of the oven up to 400°C was found to be 15 minutes. At this stage, the temperature, the time required for raising the temperature and the time for maintaining the temperature at that level were not restricted to specific ones. It is accordingly sufficient that they are appropriately set at levels which never impair the quality of the resulting porous film (for instance, they never cause any breakage of the pores).

After the preparation of the porous silica film according to the foregoing method, the pressure in the vertical type firing oven was once reduced to a level of not more than 400 Pa, while maintaining the temperature thereof at 400°C. Then there was introduced, into the oven, a mixed gas comprising 1,3,5,7-tetramethyl-cyclotetrasiloxane (TMCTS) gas in a flow rate of 0.7 g/min and N₂ gas as a carrier gas and the porous silica film was fired, while maintaining the pressure in the firing oven at a level of 500 Pa for 30 minutes. Thereafter the pressure in the oven was raised up to 8 kPa and the silica film was further fired for 60 minutes. At this stage, the mixed gas comprising TMCTS gas + N₂ gas was always passed through the oven during the firing operation so that these gases did not remain in the oven at all. The oven was evacuated to a vacuum immediately after the completion of the firing and then the temperature thereof was reduced to thus remove the substrate from the oven.

It was found that the inner wall surface of the pores present in the modified porous silica film thus formed was covered with a hydrophobic polymer thin film (polymethyl siloxane film).

The resulting porous silica film was inspected for the relative dielectric constant (k) (determined according to the mercury probe technique), refractive index (n(633 nm)) (determined, at a wavelength of 633 nm, according to the spectrometric ellipsometry), and elastic modulus (E) and hardness (H) (determined according to the nano-indentation technique).

The physical properties of the film (A) obtained according to the present invention in this Example are summarized in the following table 2, together with those observed for the film (B), as a comparative sample, obtained by repeating the same procedures used for preparing the film (A) except for omitting the firing operation within the mixed gas comprising TMCTS gas + N₂ gas and for subjecting the resulting film to a treatment with hexamethyl disilazane (HMDS) for making the film hydrophobic.

**Table 2:**

| Kinds of Porous Silica Films | k | n(633 nm) | E(GPa) | H(GPa) |
|---|---|---|---|---|
| Modified Porous Silica Film (A) in Ex. 2 | 2.10 | 1.209 | 3.78 | 0.43 |
| Film (B) Obtained by Treating with HMDS | 2.11 | 1.210 | 3.58 | 0.33 |

As will be clear from the data listed in Table 2, the modified porous silica film subjected to the firing operation carried out in the TMCTS/N₂ gas mixture has improved mechanical strength or an improved elastic modulus and an improved hardness and in particular, a highly improved hardness, as compared with those observed for the porous silica film free of any such firing operation, while maintaining the relative dielectric constant and refractive index values almost identical to those observed for the latter film.

### Example 3

A transparent uniform coating solution was prepared by stirring, in ethanol solvent, 0.85 mole of tetraethoxy-silane (TEOS), 11 moles of water, 0.15 mole of dimethyl diethoxy silane (DMDEOS) and 0.12 mole of a nonionic surfactant (P450 available from Asahi Denka Kogyo K.K.; average molecular weight: 2300; OH(CH₂CH₂O)₁₃(CH(CH₃)CH₂O)₂₀(CH₂CH₂O)₁₃H) under a strongly acidic environment at room temperature.

In this regard, the amount of the DMDEOS is not restricted to any specific one, as in Example 2, but if this substance is not used, the porous silica film obtained after the firing operation shows X-ray diffraction peaks which are attributable to the presence of the two-dimensional hexagonal pore-arrangement. In other words, the resulting porous silica film is completely free of the so-called Worm Hole-like pore structure and the resulting film in turn has a high relative dielectric constant.

The coating solution thus obtained was applied onto the surface of a semiconductor Si substrate according to the spin-coating technique, which was carried out at a rotational speed of 1,200 rpm. Thereafter, the substrate thus treated was introduced into a known vertical type firing oven in which the thermal vapor-phase growth technique could be performed according to the batch-wise manner and then the substrate was subjected to a firing treatment at 425°C for one hour in an atmosphere of 4:1 N₂/O₂ gas mixture to thus obtain a porous silica film. The time required for raising the temperature of the oven up to 425°C was found to be 25 minutes. At this stage, the temperature, the time required for raising the temperature and the time for maintaining the temperature at that level were not restricted to specific ones, as in Example 2. It is accordingly sufficient that they are appropriately set at levels which never impair the quality of the resulting porous film (for instance, they never cause any breakage of the pores).

After the preparation of the porous silica film according to the foregoing method, the pressure in the vertical type firing oven was once reduced to a level of not more than 0.4 Pa, while maintaining the temperature thereof at 425°C. Then there was introduced, into the oven, a mixed gas comprising 1,3,5,7-tetramethyl-cyclotetrasiloxane (TMCTS) gas in a flow rate of 0.7 g/min and N₂ gas as a carrier gas and the porous silica film was fired, while maintaining the pressure in the firing oven at a level of 24 Pa for 30 minutes. Thereafter the flow rate of the TMCTS introduced into the oven was increased up to 1.4 g/min and the silica film was further fired for 60 minutes, while maintaining the temperature and the pressure at the same levels used above. At this stage, the mixed gas comprising TMCTS gas + N₂ gas was always passed through the oven during the firing operation so that these gases did not remain in the oven. The oven was evacuated to a vacuum immediately after the completion of the firing and then the temperature thereof was reduced to thus remove the substrate from the oven.

It was found that the inner wall surface of the pores present in the modified porous silica film thus formed was covered with a hydrophobic polymer thin film (polymethyl siloxane film).

The resulting porous silica film (C) was inspected for the relative dielectric constant (k), refractive index (n (633 nm)), and elastic modulus (E) and hardness (H), according to the same methods used in Example 2.

The physical properties of the film (C) obtained according to the present invention in this Example are summarized in the following table 3, together with those observed for the film (D), as a comparative sample, obtained by repeating the same procedures used for preparing the film (C) except for omitting the firing operation within the TMCTS/N₂ gas mixture and for subjecting the resulting film to a treatment with hexamethyl disilazane (HMDS) for making the film hydrophobic.

**Table 3:**

| Kinds of Porous Silica Films | k | n(633 nm) | E(GPa) | H(GPa) |
|---|---|---|---|---|
| Modified Porous Silica Film (C) in Ex. 3 | 2.07 | 1.239 | 8.09 | 1.05 |
| Film (D) Obtained by Treating with HMDS | 2.06 | 1.225 | 5.95 | 0.68 |

As will be clear from the data listed in Table 3, the modified porous silica film subjected to the firing operation carried out in the TMCTS/N₂ gas mixture has substantially improved mechanical strength or it is substantially improved in the both elastic modulus and hardness, as compared with those observed for the porous silica film free of any such firing operation, while maintaining the relative dielectric constant and refractive index values almost identical to those observed for the latter film.

### Industrial Applicability

The present invention can provide a modified porous silica film, which has a low relative dielectric constant and a low refractive index and which is excellent in the mechanical strength and hydrophobicity, as well as a semiconductor device obtained using this modified porous silica film and therefore, the modified porous silica film can be used as an electrical insulating film having a low relative dielectric constant and used in the field of semiconductor and can likewise be used as a film having a low refractive index and used in the field of display.

## Claims

1. A method for the preparation of a modified porous silica film comprising the step of forming a polymer thin film on inner walls of holes present in a raw porous silica film through a gas-phase polymerization reaction, under reduced pressure, of a hydrophobic compound having at least one each of hydrophobic group and polymerizable group.

2. A method for the preparation of a modified porous silica film comprising the steps of reducing the pressure in a processing chamber after the introduction of a raw porous silica film into the processing chamber, introducing, into the processing chamber, the vapor of a hydrophobic compound having at least one each of hydrophobic group and polymerizable group together with a carrier gas, and forming a polymer thin film on inner walls of holes present in the raw porous silica film through a gas-phase polymerization reaction, under reduced pressure, of the hydrophobic compound.

3. The method for the preparation of a modified porous silica film as set forth in claim 1 or 2, wherein the foregoing reduced pressure falls within the range of from 1 X 10⁻⁵Pa to 30 kPa.

4. The method for the preparation of a modified porous silica film as set forth in any one of claims 1 to 3, wherein the hydrophobic group is an alkyl group having 1 to 6 carbon atoms or a group: -C₆H₅, and wherein the polymerizable group is a hydrogen atom, a hydroxyl group or a halogen atom.

5. The method for the preparation of a modified porous silica film as set forth in any one of claims 1 to 3, wherein the hydrophobic compound is an organic silicon atom-containing compound having at least one bond represented by the formula: Si-X-Si (in the formula, X represents an oxygen atom, an NR group, a -CₙH₂ₙ group, or a -C₆H₄ group, R represents -CₘH₂ₘ₊₁ group or a -C₆H₅ group, n is an integer of 1 or 2, m is an integer ranging from 1 to 6) and at least two bonds represented by the formula: Si-A (in the formula, A represents a hydrogen atom, a hydroxyl group, a -OCₑH₂ₑ₊₁ group or a halogen atom, a plurality of groups A present in the same molecule may be the same or different, and e is an integer ranging from 1 to 6).

6. The method for the preparation of a modified porous silica film as set forth in claim 1, wherein the hydrophobic compound is a cyclic siloxane.

7. A modified porous silica film **characterized in that** it is prepared according to the method as set forth in any one of claims 1 to 6.

8. A semiconductor material **characterized in that** the modified porous silica film as set forth in claim 7 is used.

9. A semiconductor device **characterized in that** the semiconductor material as set forth in claim 8 is used.
